# DEMANDE DE BREVET EUROPEEN

(11) **EP 4 661 062 A1**
(43) Date de publication de la demande: **10.12.2025**
(21) Numéro de dépôt: 25178611.7
(22) Date de dépôt: 23.05.2025
(51) Int. Cl.: H01L 21/50, H01L 23/04, H01L 23/552, H01L 25/16, H10F 55/255, H10H 20/85, H10H 20/857

(54) **CAPOTAGE DE BLINDAGE ÉLECTROMAGNÉTIQUE POUR CIRCUIT ÉLECTRONIQUE**

(30) Priorité: 30.05.2024 FR 2405583
(71) Demandeur: STMicroelectronics International N.V., 1228 Plan-les-Ouates, Geneva (CH)
(72) Inventeur: MASTROMAURO, Nicolas, 38660 LUMBIN (FR); SAXOD, Karine, 73800 PORTE DE SAVOIE (FR)
(74) Mandataire: Cabinet Beaumont

(57) **Abrégé**

La présente description concerne un capot (100) de blindage électromagnétique pour circuit électronique comprenant une face principale (101) et quatre faces latérales (102, 103, 104, 105), une des faces latérales (102) ayant, au niveau de sa base, des zones de brasage (110), chaque zone de brasage (110) étant délimitée par plusieurs ouvertures (120).

Elle concerne également un circuit électronique, notamment un circuit d'émission et/ou de réception optique, comprenant une puce (350) fixée sur une première face principale (301) d'un substrat (300) et un tel capot (100), la première face principale (301) du substrat étant recouverte localement par des plots métalliques (310), le capot (100) et le substrat (300) étant assemblés l'un à l'autre au moyen de joints de brasage (400), chaque joint de brasage (400) étant brasé sur un des plots métalliques (310) et sur une des zones de brasage (110).

## Description

### Domaine technique

La présente description concerne de façon générale le domaine des circuits électroniques, et plus particulièrement les capots de blindage électromagnétique destinés à protéger les circuits électroniques, notamment ceux incluant des émetteurs de rayonnements lumineux et/ou des récepteurs de rayonnements lumineux.

### Technique antérieure

Certains circuits électroniques comprennent une puce électronique logée dans un boîtier. Le boîtier comprend typiquement une partie support sur laquelle la puce est fixée, et une partie couvercle recouvrant la puce. Le couvercle est monté sur la partie support. Il est, par exemple, en résine.

Lorsque les puces électroniques comprennent des régions d'émission et de réception de signaux optiques, la partie couvercle comprend, en regard des régions d'émission/réception des éléments transparents aux longueurs d'ondes des signaux optiques et une paroi interne, délimitant deux cavités, une pour la région d'émission et une pour la région de réception.

De tels circuits électroniques sont, par exemple, utilisés pour réaliser des détecteurs de proximité par mesure de temps de vol (TOF pour "time-of-flight") pour détecter la présence ou l'absence d'un objet situé face au couvercle du boîtier.

Comme de tels circuits électroniques sont sensibles aux ondes électromagnétiques, un blindage électromagnétique doit être ajouté. Pour cela, un capot métallique peut être positionné sur le couvercle. Il peut être solidarisé au substrat support par l'intermédiaire d'un cordon de colle.

Néanmoins, du fait des difficultés de calibrage des cordons, plusieurs inconvénients apparaissent. Il existe un risque que la matière de collage flue par capillarité, à l'intérieur du capot, pouvant gêner le bon fonctionnement du composant électronique. En outre, la solidité de la fixation de capot est aléatoire.

### Résumé de l'invention

Il existe un besoin de fournir un capot de blindage électromagnétique pour circuit électronique pouvant être facilement assemblé sur un circuit électronique afin de le protéger des ondes électromagnétiques et un procédé d'assemblage d'un circuit électronique mettant en œuvre un tel capot, le capot obtenu devant présenter une bonne tenue mécanique.

Cet objet est atteint par un capot de blindage électromagnétique pour circuit électronique comprenant une face principale et quatre faces latérales, une première face latérale ayant, au niveau de sa base, des zones de brasage, chaque zone de brasage étant délimitée par plusieurs ouvertures.

Selon un mode de réalisation particulier, chaque zone de brasage est délimitée par trois ouvertures formées d'une ouverture supérieure et deux ouvertures latérales, les ouvertures latérales étant perpendiculaires à l'ouverture supérieure et perpendiculaires à la base de la première face latérale.

Selon un mode de réalisation particulier, la première face latérale a une hauteur inférieure à la hauteur des autres faces latérales.

Selon un mode de réalisation particulier, le capot est en métal, de préférence en acier inoxydable ou en cuivre.

Cet objet est également atteint par procédé de fabrication d'un capot de blindage électromagnétique pour circuit électronique, tel que défini précédemment, procédé dans lequel les ouvertures du capot sont formées par poinçonnage.

Cet objet est également atteint par un circuit électronique, notamment un circuit d'émission et/ou de réception optique, comprenant une puce fixée sur une première face principale d'un substrat et un capot de blindage électromagnétique tel que défini précédemment, la première face principale du substrat étant recouverte localement par des plots métalliques, le capot et le substrat étant assemblés l'un à l'autre au moyen de joints de brasage, chaque joint de brasage étant brasé à la fois sur un des plots métalliques du substrat et sur une des zones de brasage du capot.

Selon un mode de réalisation particulier, au moins l'une des autres faces latérales du capot recouvre un des flancs du substrat, de préférence dans lequel les trois autres faces latérales recouvrent chacune un des flancs du substrat.

Selon un mode de réalisation particulier, un capot additionnel en matériau polymère est positionné sur la première face du substrat et est recouvert par le capot de blindage électromagnétique, le capot additionnel définissant une cavité dans laquelle est positionnée la puce, le capot de blindage électromagnétique pouvant être fixé au capot additionnel au moyen d'une couche de colle.

Selon un mode de réalisation particulier, le rapport de surface entre une zone de brasage et un plot métallique, brasés l'un à l'autre, est d'environ 1.

Selon un mode de réalisation particulier, le capot recouvre au moins 80%, de préférence au moins 90%, de la surface de la première face principale du substrat.

Cet objet est également atteint par un procédé de fabrication d'un circuit électronique tel que défini précédemment, le procédé comprenant :
- une étape au cours de laquelle on positionne un capot de blindage électromagnétique pour circuit électronique, tel que défini précédemment, sur une première face principale d'un substrat, une puce étant disposée sur la première face principale du substrat, une périphérie de la première face principale du substrat étant recouverte localement par des plots métalliques, le capot étant positionné de manière à ce que les zones de brasage soient disposées au niveau des plots métalliques du substrat,
- une étape de brasage au cours de laquelle des joints de brasage sont formés, chaque joint de brasage étant brasé à la fois sur un des plots métalliques du substrat et sur une des zones de brasage du capot.

Selon un mode de réalisation particulier, l'étape de brasage est réalisée par jet de billes de brasure.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, en vue éclatée, un circuit électronique selon un mode de réalisation particulier ;
la figure 2 représente, en trois dimensions, une partie d'un circuit électronique, selon un mode de réalisation particulier ;
la figure 3 représente, en vue de face, une partie d'un circuit électronique, selon un mode de réalisation particulier ; et
la figure 4A et la figure 4B représentent, de manière schématique, et en vue de face, des joints de brasage d'un circuit électronique, selon différents modes de réalisation.

Les différents éléments ne sont pas nécessairement tous à la même échelle afin de rendre les figures plus lisibles.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

Par entre X et Y, on entend que les bornes X et Y sont incluses dans la plage de valeurs.

Par onde radiofréquence, on entend une onde électromagnétique dont la fréquence est située entre 3 kHz et 3000 GHz, plus particulièrement entre 3 kHz et 6 GHz, et encore plus particulièrement 100 kHz et 6 GHz.

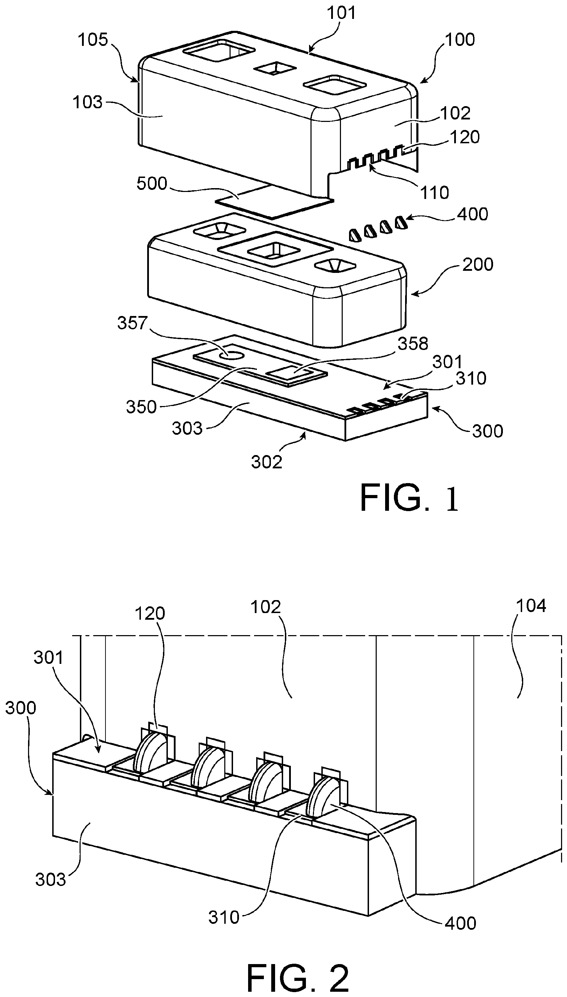

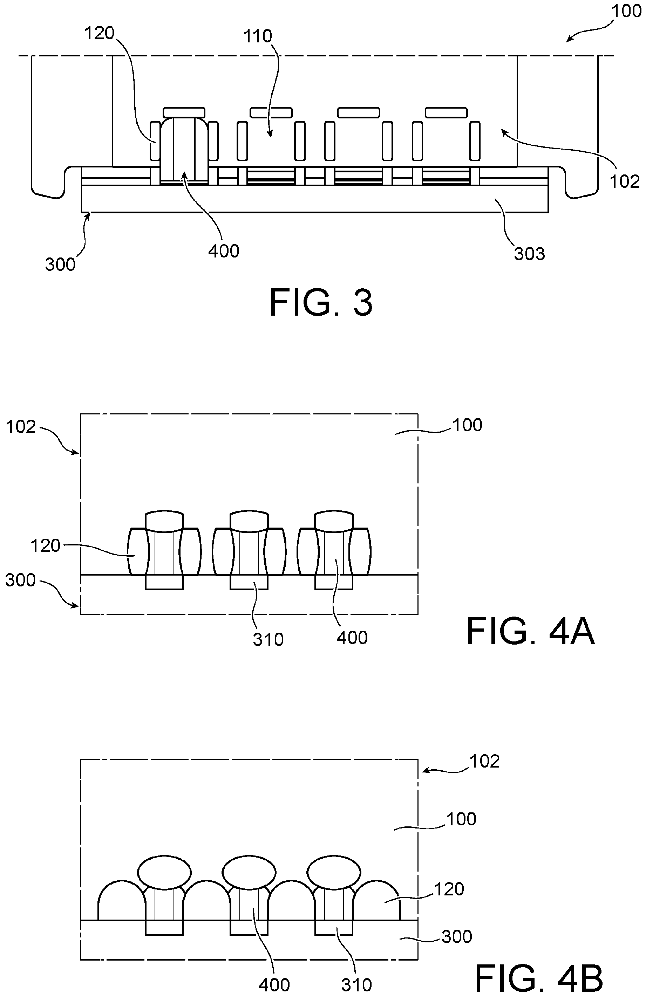

Nous allons décrire en détail les différents éléments du circuit électronique en faisant référence à la figure 1, à la figure 2 et à la figure 3.

Le circuit électronique comprend un substrat support 300 sur lequel est positionnée une puce électronique 350, un premier capot dit capot externe 100 et un deuxième capot dit capot interne 200. Le capot externe 100 recouvre le capot interne 200. Le capot externe 100 joue le rôle de blindage électromagnétique, notamment vis-à-vis des radiofréquences.

Le substrat support 300 (aussi appelé substrat ou support) comprend une première face principale 301 (face avant), une deuxième face principale 302 (face arrière) sensiblement parallèle à la première face principale et des flancs 303. Les flancs 303 vont de la première face principale 301 à la deuxième face principale 302. Le contour du substrat support est, par exemple, carré ou rectangulaire.

Une partie de la périphérie de la première face 301 du substrat support 300 est recouverte par des plots métalliques 310 destinés à l'assemblage avec le capot externe 100. Les plots métalliques 310 peuvent être disposés sur deux côtés de la première face 301 afin de fixer le capot 100 sur deux côtés du substrat 300. Les plots métalliques 310 sont, de préférence, disposés sur un seul et même côté de la première face 301.

Les plots métalliques 310 sont en un métal ou en un alliage de métal. Les plots métalliques 310 sont, par exemple, en cuivre.

Le substrat support 300 est en un matériau diélectrique. Il comprend des connexions électriques (non représentées) allant de la première face principale 301 à la deuxième face principale 302.

Le substrat 300 est un substrat d'interconnexion permettant de relier le circuit électronique à un dispositif extérieur ou à un substrat de type PCB (carte de circuit imprimé ou 'printed circuit board').

La face arrière 302 du substrat support 300 peut être pourvue de plots métalliques électrique pour connecter le boitier électronique à un élément extérieur.

La puce électronique 350 (notée plus simplement puce) 350 est disposée sur le substrat 300 et plus particulièrement sur la première face principale 301 du substrat support 300. Elle est, par exemple, disposée sur une partie centrale du support 300.

La puce 350 est reliée électriquement au réseau de connexions électriques du substrat support 300 par l'intermédiaire d'un élément assurant la connexion électrique, comme des fils ou des billes. Une couche de colle (non représentée) peut être interposée entre la face avant 301 du substrat support 300 et une face arrière de la puce électronique 350.

Selon un mode de réalisation, la puce 350 comprend une partie d'émission optique 357 et une partie de réception optique 358.

La partie photoémettrice 357 est configurée pour émettre un signal lumineux et la partie photoréceptrice 358 est configurée pour détecter un signal lumineux incident. La partie photoémettrice 357 et la partie photoréceptrice 358 sont destinées à coopérer de façon à mesurer une distance par temps de vol du signal lumineux émis puis incident après une réflexion.

Alternativement, deux puces pourraient être utilisées, l'une étant une puce photoémettrice configurée pour émettre un signal lumineux et l'autre puce étant une puce photoréceptrice configurée pour détecter un signal lumineux incident.

Le circuit électronique comprend un capot interne 200 situé au-dessus et à distance de la puce 350, parallèlement au substrat support 300. Le capot interne 200 comprend une face principale (aussi appelée face avant ou face supérieure) et des faces latérales. La puce est logée dans le capot interne 200.

Le capot interne 200 présente un contour inférieur à celui du substrat support 300. Les pieds des faces latérales sont assemblés mécaniquement sur la première face 301 du substrat 300. L'assemblage peut être réalisé au moyen d'un adhésif ou d'une colle.

Le capot interne 200 comprend une ou plusieurs parois internes sous forme de plaques. Les parois sont opaques.

La ou les parois internes séparent les régions d'émission/réception optique 357, 358 de la puce 350.

Le capot interne 200 peut comprendre des éléments transparents, par exemple en verre, tels que des lentilles ou des filtres, situés en regard des régions d'émission/réception optique 357, 358 de la puce 350.

Le filtre optique peut être configuré pour être transparent sélectivement pour une gamme de longueur d'ondes donnée, typiquement la gamme comprenant la longueur d'onde du signal émis par la partie photoémettrice 357, par exemple les infrarouges.

Le capot interne 200 est un matériau polymère, par exemple, en une résine thermo-durcie. Il s'agit par exemple d'une résine époxy.

La face supérieure du capot interne 200 est assemblé mécaniquement au capot externe 100, par exemple par une couche 500 de colle ou d'adhésif, disposée entre les deux capots 100, 200.

Le capot externe 100 comprend une face principale 101 (aussi appelée face avant ou face supérieure) et quatre faces latérales (une première face latérale 102, une deuxième face latérale 103, une troisième face latérale 104 et une quatrième face latérale 105).

Le capot externe 100 comprend une chambre définissant un espace libre pour accueillir le capot interne 200.

Le capot externe 100 peut comprendre des éléments transparents, par exemple en verre, tels que des lentilles ou des filtres, situés en regard des régions d'émission/réception optique 357, 358 de la puce 350. Les éléments transparents du capot interne 100 sont superposés aux éléments transparents du capot externe 200.

Le filtre optique peut être configuré pour être transparent sélectivement pour une gamme de longueur d'ondes donnée, typiquement la gamme comprenant la longueur d'onde du signal émis par la partie photoémettrice 357, par exemple les infrarouges.

Le capot externe 100 est un capot métallique. Il est, par exemple, en acier inoxydable, communément appelé acier inox, ou en cuivre. L'acier inoxydable peut être en SUS 430 ou en SUS 316L. Le capot externe 100 peut être nickelé (i.e. recouvert de nickel).

Une première face latérale 102 a, au niveau de sa base (aussi appelé pied), des zones de brasage 110. Chaque zone de brasage est délimitée par plusieurs ouvertures 120. Il y a au moins deux ouvertures, par exemple trois ouvertures.

Les zones de brasage 110 sont des zones situées sur la face latérale 102 du capot 100.

Par ouverture, on entend une ouverture traversante. Autrement dit, l'ouverture traverse toute l'épaisseur de la première face latérale 102.

Les ouvertures ont, de préférence, une forme allongée, c'est-à-dire un rapport longueur/largeur supérieur à 2 et de préférence supérieur à 4.

Comme représenté sur les figures 4A et 4B, les ouvertures 120 peuvent avoir différentes formes. Elles peuvent être, par exemple, rectangulaires (figure 4A) ou avoir une forme d'ellipse (figure 4B).

Les ouvertures 120 peuvent avoir des formes identiques ou différentes. De préférence, elles sont identiques.

De préférence, chaque zone de brasage 110 est délimitée par trois ouvertures 120 : deux ouvertures latérales et une ouverture supérieure. Une ouverture latérale peut être commune à deux zones de brasage 110. Les deux ouvertures latérales d'une zone de brasage 110 sont parallèles entre elles. L'ouverture supérieure est perpendiculaire aux ouvertures latérales et parallèle à la base de la première face 102.

Le capot externe 100 a au moins une zone de brasage 110, de préférence au moins deux zones de brasage 110. Il a, par exemple, quatre zones de brasage.

Les zones de brasage 110 sont de préférence formées sur une seule face latérale du capot 100. Elles pourraient être positionnées sur deux faces latérales opposées, notamment sur la première face 102 et sur la troisième face 104.

La surface des zones de brasage 110 est, de préférence, identique à la surface des plots métalliques 310 du substrat support 300.

Une fois assemblées, au moins 80%, de préférence, au moins 90% et encore plus préférentiellement au moins 95% de la surface de la première face 301 du substrat 300 est couverte par le capot externe 100.

La première face latérale 102 a une première hauteur. Les deuxième 103, troisième 104 et quatrième 105 faces latérales ont respectivement une deuxième, troisième et quatrième hauteurs. La première hauteur est inférieure à au moins l'une de la deuxième, troisième et quatrième hauteur. De préférence, elle est inférieure aux deuxième, troisième et quatrième hauteurs. Ainsi, lors du positionnement du capot 100 sur le substrat 300, les deuxième 103, troisième 104 et quatrième 105 faces latérales recouvrent les flancs 303 du substrat support 300. Le blindage électromagnétique obtenu est ainsi particulièrement performant.

De préférence, les faces latérales 103, 104, 105 couvrent au moins 50%, encore plus préférentiellement au moins 80% et de manière encore plus préférentielle la totalité de la hauteur des flancs 303 du substrat 300.

Un tel capot de blindage électromagnétique peut être fabriqué par un procédé comprenant une étape de poinçonnage au cours de laquelle les ouvertures 120 sont formées par perforation du capot 100.

Le substrat support 300 et le capot externe 100 sont assemblés mécaniquement au moyen de joints de brasage 400.

Plus particulièrement, la phase d'assemblage comprend :
- une mise en contact du capot 100 avec le substrat support 300, et plus particulièrement avec la première face 301 du substrat support 300, qui sert de surface d'appui, et
- une solidarisation du capot 100 avec le substrat support 300.

La solidarisation est réalisée au moyen d'une étape de brasage. De préférence, le brasage est un brasage par projection de brasure ('jet-soldering') au cours duquel on réalise un jet de billes de brasure. Pour solidariser le capot 100 et le substrat 300, des billes en un matériau de brasage (à l'état fondu) sont projetées sur les surfaces à assembler (ici au niveau de la zone de contact entre les plots métalliques 310 du substrat support 300 et des zones de brasage 110) et, lors du refroidissement du matériau de brasage, des joints de brasage 400 sont formés.

Lors du brasage, les zones de brasage 110 du capot externe 100 sont mouillées par les billes. Les ouvertures 310 latérales permettent de limiter latéralement la propagation du matériau de brasage (et éviter les courts-circuits entre les joints de brasage). L'ouverture 310 supérieure limite la propagation du matériau de brasage 400 vers le haut du capot 300. Les joints de brasage 400 obtenus présentent un bon rapport entre la surface de la zone de brasage 110 recouverte par le joint de brasage 400 et le volume du joint de brasage 400. Les joints de brasage 400 obtenus présentent un bon rapport entre la surface du plot 310 du substrat support 300 recouverte par le joint de brasage 400 et le volume du joint de brasage 400. La tenue mécanique des joints de brasage 400 dans le temps est améliorée.

Après le brasage, chaque joint de brasage 400 est en contact, d'une part, avec les zones de brasage 110 du capot 100 et, d'autre part, avec les plots métalliques 310 du substrat 300.

Du côté du substrat support 300, l'extension du joint de brasage 400 est définie par les plots 310.

Le diamètre des billes est, par exemple, de 250µm pour des plots métalliques ayant une surface de 250µm x 180µm ou de 250µm x 250µm.

Les billes sont en un matériau de brasage (ou matériau brasable), de préférence, choisi parmi l'étain et un alliage d'étain, comme par exemple SnAg, SnAgCu (noté SAC).

Avec un tel procédé, il n'y a pas besoin de mettre en œuvre une étape supplémentaire de recuit thermique.

Un tel procédé est simple et peu coûteux à mettre en œuvre.

Le circuit électronique obtenu présente une bonne tenue mécanique et un blindage électromagnétique efficace.

Le circuit électronique est notamment un circuit électronique d'émission et/ou de réception optique et, en particulier, un dispositif TOF de mesure par temps de vol (« time of flight »). La partie photoémettrice 357 est configurée pour émettre un signal lumineux. Le signal sort du capot interne 200 et du capot externe 100. Une surface photosensible de référence de la partie photoréceptrice 358 détecte immédiatement le signal sortant émis par la partie photoémettrice 357, de façon à définir un instant d'émission du signal. Le signal sortant est destiné à être réfléchi ou diffusé sur un élément à l'extérieur du capot externe 100. Le signal réfléchi ou diffusé est dirigé vers la partie photosensible de détection 358. La partie photoréceptrice 358 détecte ainsi un instant de réception du signal réfléchi, et la durée écoulée entre l'instant d'émission et l'instant de réception est directement proportionnelle à la distance séparant le dispositif TOF de l'objet extérieur.

Un tel circuit électronique trouve des applications, notamment, dans le domaine de la téléphonie mobile. Il trouve également des applications dans de d'autres domaines industriels.

Le dispositif est, par exemple, destiné à l'industrie automobile.

Le dispositif peut par exemple être utilisé dans le domaine industriel.

Le dispositif peut également être utilisé dans le domaine de l'internet des objets et des maisons intelligentes.

Il peut être utilisé dans les communications en champ proche (ou NFC pour 'near-field communication').

Le dispositif peut également être utilisé dans la mise en œuvre de réseaux 5G, de centres de données et de serveurs.

Le dispositif est, par exemple, destiné à être utilisé dans de l'électronique personnelle, dans les dispositifs de connexions 5G ou plus généralement dans les dispositifs connectés.

Le dispositif est, par exemple, destiné à être utilisé dans des équipements de communication, ou dans des ordinateurs et des périphériques.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Capot (100) de blindage électromagnétique pour circuit électronique comprenant une face principale (101) et quatre faces latérales (102, 103, 104, 105), une première face latérale (102) ayant, au niveau de sa base, des zones de brasage (110), chaque zone de brasage (110) étant délimitée par trois ouvertures (120) formées d'une ouverture supérieure et deux ouvertures latérales, les ouvertures latérales étant perpendiculaires à l'ouverture supérieure et perpendiculaires à la base de la première face latérale (102).

2. Capot selon la revendication 1, dans lequel la première face latérale (102) a une hauteur inférieure à la hauteur des autres faces latérales (103, 104, 105).

3. Capot selon l'une quelconque des revendications précédentes, dans lequel le capot (100) est en métal, de préférence en acier inoxydable ou en cuivre.

4. Procédé de fabrication d'un capot de blindage électromagnétique pour circuit électronique (100), comprenant une face principale (101) et quatre faces latérales (102, 103, 104, 105), une première face latérale (102) ayant, au niveau de sa base, des zones de brasage (110), chaque zone de brasage (110) étant délimitée par trois ouvertures (120) formées d'une ouverture supérieure et deux ouvertures latérales, les ouvertures latérales étant perpendiculaires à l'ouverture supérieure et perpendiculaires à la base de la première face latérale (102), procédé dans lequel les ouvertures (120) du capot (100) sont formées par poinçonnage.

5. Circuit électronique, notamment un circuit d'émission et/ou de réception optique, comprenant une puce (350) fixée sur une première face principale (301) d'un substrat (300) et un capot (100) de blindage électromagnétique selon l'une quelconque des revendications 1 à 3, la première face principale (301) du substrat étant recouverte localement par des plots métalliques (310), le capot (100) et le substrat (300) étant assemblés l'un à l'autre au moyen de joints de brasage (400), chaque joint de brasage (400) étant brasé à la fois sur un des plots métalliques (310) du substrat (300) et sur une des zones de brasage (110) du capot (100).

6. Circuit électronique selon la revendication 5, dans lequel au moins l'une des autres faces latérales (103, 104, 105) du capot (100) recouvre un des flancs (303) du substrat (300), de préférence dans lequel les trois autres faces latérales recouvrent chacune un des flancs (303) du substrat (300).

7. Circuit électronique selon l'une des revendications 5 et 6, dans lequel un capot additionnel (200) en matériau polymère est positionné sur la première face (301) du substrat (300) et est recouvert par le capot (100) de blindage électromagnétique, le capot additionnel définissant une cavité dans laquelle est positionnée la puce (350), le capot (100) de blindage électromagnétique pouvant être fixé au capot additionnel (200) au moyen d'une couche de colle (400).

8. Circuit électronique selon l'une des revendications 5 à 7, dans lequel le rapport de surface entre une zone de brasage (110) et un plot métallique (310), brasés l'un à l'autre, est d'environ 1.

9. Circuit électronique selon l'une quelconque des revendications 5 à 8, dans lequel le capot (100) recouvre au moins 80%, de préférence au moins 90%, de la surface de la première face principale (301) du substrat (300).

10. Procédé de fabrication d'un circuit électronique selon l'une des revendications 5 à 9, le procédé comprenant :
- une étape au cours de laquelle on positionne un capot (100) de blindage électromagnétique pour circuit électronique, tel que défini dans l'une des revendications 1 à 3, sur une première face principale (301) d'un substrat (300), une puce (350) étant disposée sur la première face principale (301) du substrat (300), une périphérie de la première face principale (301) du substrat (300) étant recouverte localement par des plots métalliques (310), le capot (100) étant positionné de manière à ce que les zones de brasage (110) soient disposées au niveau des plots métalliques (310) du substrat (300),
- une étape de brasage au cours de laquelle des joints de brasage (400) sont formés, chaque joint de brasage (400) étant brasé à la fois sur un des plots métalliques (310) du substrat (300) et sur une des zones de brasage (110) du capot (100).

11. Procédé selon la revendication 10, dans lequel l'étape de brasage est réalisée par jet de billes de brasure.
